Europäisches Patentamt

European Patent Office

Office européen des brevets

(11) Publication number: **0 304 868**
**A2**

## (12) EUROPEAN PATENT APPLICATION

(21) Application number: **88113700.4**

(22) Date of filing: **23.08.88**

(51) Int. Cl.⁴: **G01R 1/073**

(30) Priority: **28.08.87 US 90802**

(43) Date of publication of application:
**01.03.89 Bulletin 89/09**

(84) Designated Contracting States:
**DE FR GB**

(71) Applicant: **TEKTRONIX, INC.**
**Howard Vollum Park 14150 Karl Braun Drive**
**P.O. Box 500**
**Beaverton Oregon 97077(US)**

(72) Inventor: **Barsotti, Christina C.**
**617 West 45th Street**
**Vancouver Washington 98660(US)**
Inventor: **Harry, Emory J.**
**6777 S.W. 180th Avenue**
**Aloha Oregon 97007(US)**
Inventor: **Tremaine, Steven G.**
**608 S.E. 121st Street, No 154**
**Vancouver Washington 98684(US)**

(74) Representative: **Strasse, Joachim, Dipl.-Ing. et al**
**Strasse und Stoffregen European Patent Attorneys Zweibrückenstrasse 17**
**D-8000 München 2(DE)**

(54) **Multiple lead probe for integrated circuits in wafer form.**

㊼ A probe assembly for use in testing an integrated circuit embodied in an integrated circuit chip in wafer form comprises a support member formed with an aperture and a membrane spanning the aperture, both the support member and the membrane having conductor runs thereon. The runs of the membrane couple inner contact elements, distributed over a main face of the membrane in a pattern that corresponds to the pattern in which contact areas are distributed on the chip under test, to outer connect elements distributed about a peripheral region of the membrane. The runs of the support member couple the outer connect elements of the membrane to a testing apparatus. The inner contact elements of the membrane extend below the support board and below the lower surface of the membrane to the chip face to allow electrical contact with the contact areas of the chip.

## MULTIPLE LEAD PROBE FOR INTEGRATED CIRCUITS IN WAFER FORM

### Background of the Invention

This invention relates to a multiple lead probe for integrated circuits in wafer form.

An important aspect of the manufacture of integrated circuit chips is the testing of the circuit embodied in the chip in order to verify that it operates according to specifications. Although the circuit could be tested after the chip has been packaged, the expense involved in dicing the wafer and packaging the individual chips makes it desirable to test the integrated circuit as early as possible in the fabrication process, so that unnecessary efforts will not be expended on faulty devices. It is therefore desirable that these circuits be tested either immediately after wafer fabrication is completed, and before separation into dice, or after dicing but before packaging. In either case, it is necessary to be able to make an electrical connection to all the circuit's external connections and test points in a nondestructive way, so as not to interfere with subsequent packaging and connection operations.

It is desirable that an integrated circuit be tested under its design operating conditions and to the extremes of its design performance range. In particular, typical high speed circuits are designed to operate with input and output signal bandwidths exceeding 1 GHz, and it is necessary that operation of such circuits be evaluated at these high frequencies.

A high speed wafer probe is disclosed in U.S. Patent Application Serial No. 318,084 filed November 4, 1981. A practical implementation of the probe disclosed in that patent application is capable of supporting signal bandwidths to approximately 18 GHz, but is able to provide only a few (less than ten) connections to the chip under test. Probes that are able to provide sufficient connections for the complex integrated circuits that are currently being manufactured have inadequate bandwidth for testing high speed circuits at the extremes of their performance range.

It has previously been proposed that an integrated circuit be tested using a probe comprising a body of elastomer having conductor runs of metals deposited on one face thereof. This probe is subject to a number of disadvantages. For example, the probe is not capable of supporting signals at frequencies above a few hundred megahertz without serious signal degradation, and it has poor mechanical stability owing to the large difference in elasticity of the elastomer body and the metallic conductor runs.

### Summary of the Invention

In accordance with the invention, a probe for use in testing an integrated circuit chip comprises a support member formed with an aperature, and a flexible, elastically-deformable membrane. The membrane has first and second main faces, and is attached at one of the main faces to the support member so as to span the aperture. The membrane comprises dielectric material and portions of conductive material supported by the dielectric material in electrically-insulated relationship. The portions of conductive material of the membrane include inner contact elements exposed at the first main face of the membrane in a pattern that corresponds to the pattern of contact areas on the contact face of the integrated circuit chip, the inner contact elements being adapted to contact corresponding contact areas of the integrated chip so as to establish an electrical coupling therebetween. The portions of conductive material of the membrane further include outer connect elements distributed about a peripheral region of the membrane, and transmission lines extending from the inner contact elements to the outer connect elements respectively. The support member comprises dielectric material and portions of conductive material, supported by the dielectric material and in electrically-insulated relationship, including connect elements to provide an electrical coupling between the outer connect elements of the membrane and testing apparatus.

### Brief Description of the Drawings

For a better understanding of the invention, and to show how the same may be carried into effect, reference will now be made, by way of example, to the accompanying drawings, wherein like numerals refer to corresponding elements and in which:

FIG. 1 is a sectional view of a probe assembly embodying the present invention,

FIGS. 2 and 3 are enlarged views of portions of FIG 1,

FIG. 4 is a view of a VLSI testing apparatus making use of the probe assembly of FIG. 1,

FIG. 5 is a bottom view of the membrane of FIG. 1; and

FIG. 6 is a top view of the support board of FIG. 1.

## Detailed Description

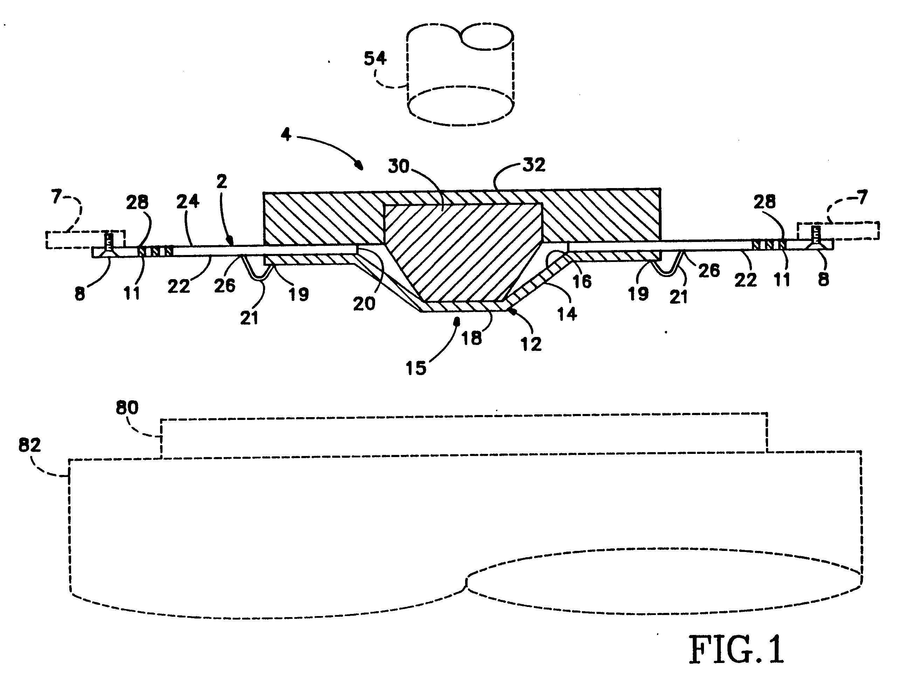

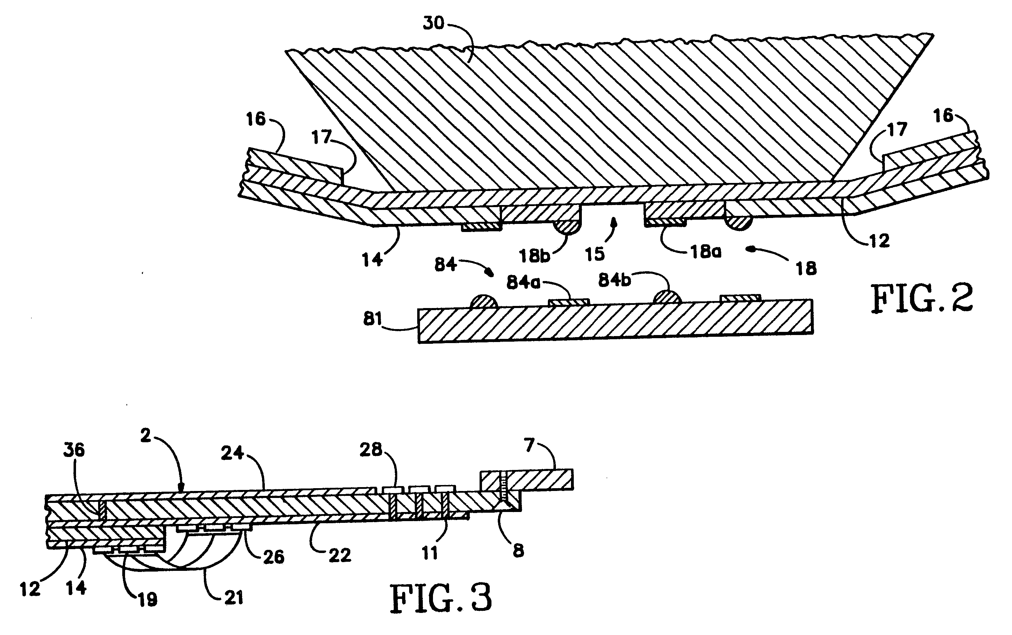

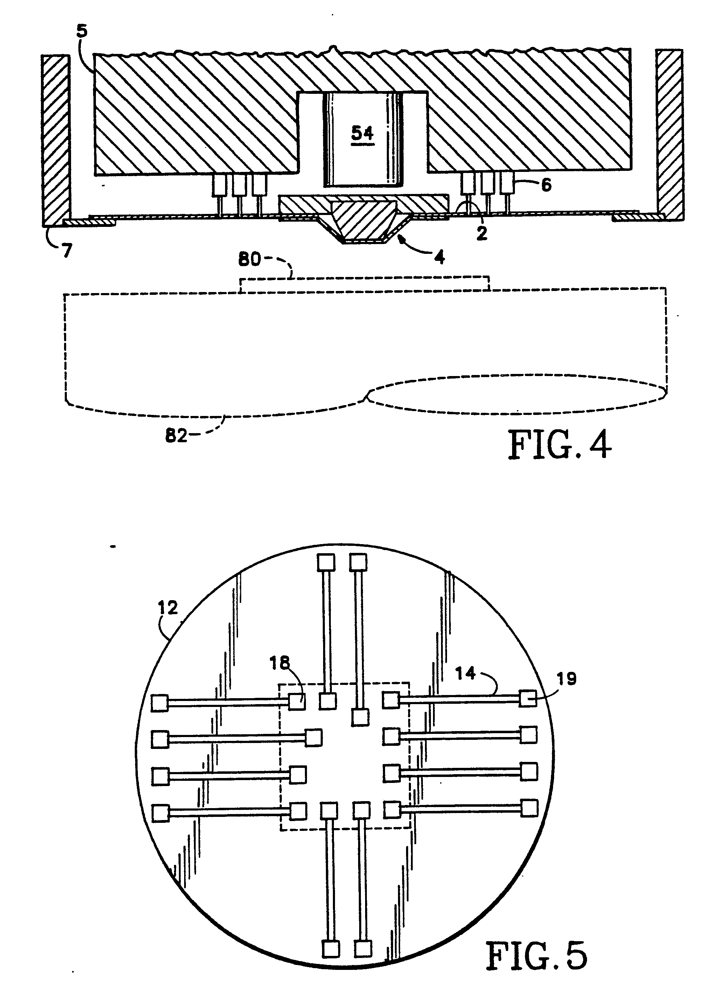

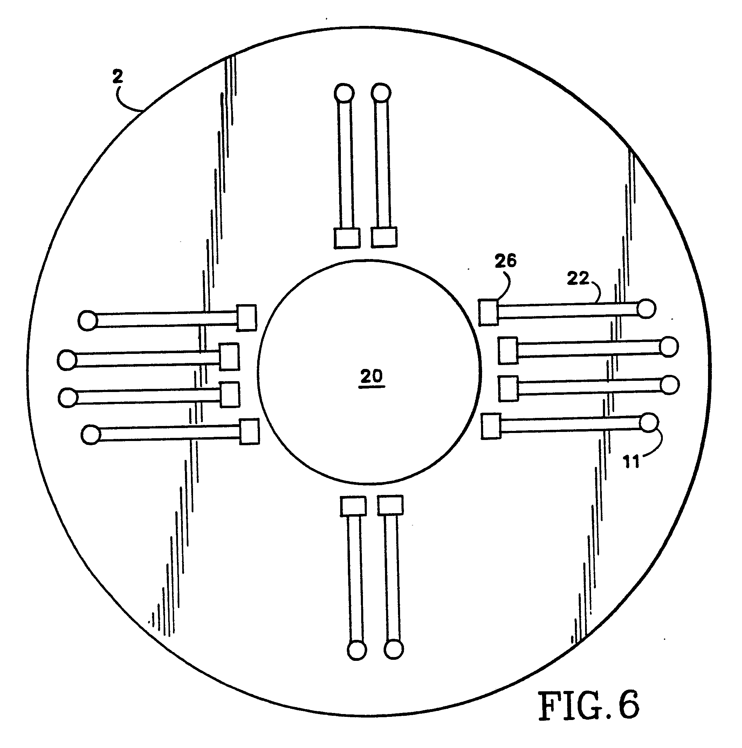

The probe assembly shown in FIGS. 1-6 comprises a support board 2 and a probe head 4. A wafer 80 including an integrated circuit chip 81 that is to be tested is mounted on a wafer support 82 and positioned beneath the probe head 4. The chip has contact areas 84 distributed over its upper face, the contact areas being in the form of a contact pad, such as contact area 84a, for providing test access to a circuit node, or a contact bump, such as contact area 84b, for making pressure connections between circuit nodes and conductors on a substrate when the integrated circuit is diced and mounted in a hybrid circuit. The face of the chip over which the contact areas 84 are distributed is referred to herein as the contact face of the chip.

The board 2 is circular, formed with a central window 20, and includes conductor runs 22 on the lower surface of the board 2 that extend between the periphery of the window 20 and the outer periphery of the board 2. The conductor runs 22 are exposed at the lower surface of the board 2 about the periphery of the window 20 to form inner connect elements 26. At the outer periphery of the board two vias 11 couple the runs 22 to outer contact elements 28 on the upper surface of board 2. The upper surface of the board 2 is covered by a ground plane 24 and the spacing between the conductors 22 and the ground plane 24 is such that each of the conductors 22 forms a separate constant impedance, microstrip transmission line with ground plane 24. The board 2 is is secured to a mechanical support 7 by screws 8.

A test head 5 includes driver circuitry for generating test signals for testing operation of the integrated circuit, and for monitoring output signals produced by the integrated circuit. The test and integrated circuit output signals are conveyed between the test head 5 and contact elements 28 on the board 2 by way of spring loaded contact pins 6 projecting downward from the lower surface of the test head 5.

The probe head 4 includes a film 12 of flexible, elastically deformable, transparent dielectric material, such as polyimide. A pattern of electrically conductive material is formed on the film 12 using standard photolithographic patterning and etching techniques. The pattern of conductive material comprises conductor runs 14 on the lower surface of the film 12 and a ground plane 16 on the upper surface of the film, the ground plane 16 having an aperture 17 therein over a central area 15 of the film 12. Aperture 17 facilitates viewing of the chip contact face from above the membrane. The conductor runs 14 extend between the central area 15 of the film 12 and a peripheral area of the film 12. At the ends of the conductor runs 14 near the central area 15, contact elements 18 are provided in the form of contact pads 18a and contact bumps 18b, and at the ends of the runs 14 near the peripheral area of the membrane connect elements 19 are provided. An electrical connection is provided between the connect elements 19 at the periphery of the film 12 and the connect elements 26 on the board 2, the connection being suitably in the form of a ribbon connector 21. Vias 36 through board 2 connect ground plane 16 to ground plane 24. When the probe head is in use, conductor runs 14 and ground plane 16 together form constant characteristic impedance microstrip transmission lines extending from the contact elements 18 to the connect elements 19. Dissimilar metals may be used for the runs 14 and the contact elements 18 by using different plating baths. Runs 14 suitably comprise gold while contact elements 18 suitably comprise palladium, in the case of pads 18a, and nickel, in the case of bumps 18b, which are conductive but less subject to wear than gold.

The geometric distribution of the contact elements 18 over the lower surface of the film 12 corresponds to the geometric distribution of contact areas 84 over the contact face of the chip 81. Further, where a contact area 84 on the contact face of the chip 81 is a bump such as the area 84b, the corresponding contact element 18 on the film 12 is a pad, such as the element 18a. Similarly, where the contact area 84 on the contact face of the chip 81 is a pad, such as the area 84a, the corresponding contact element 18 on the film 12 is a bump, such as the element 18b. The film 12 is attached to the lower surface of the board 2 and spans the window 20 such that the contact elements 18 project downwardly toward the wafer 80. Therefore, the contact elements 18 can be brought into electrically-conductive pressure contact with respective contact areas 84 of the chip 81.

The probe head 4 further includes a central flexible optical member 30 positioned above the upper surface of the film 12 at the central area 15 thereof and a central rigid optical member 32 placed on the top of the flexible optical member 30. The flexible optical member 30 and rigid optical member 32 exert pressure upon the film 12 and cause the contact elements 18 to extend downwardly beyond the lower surface of the film 12 and the board 2 such that the contact elements 18 contact the contact area 84 of the chip 81 without allowing other portions of the film 12 or the board 2 to contact the wafer 80. As the contact areas 84 of the chip 81 are brought against the contact elements 18, the flexible optical member 30 distributes pressure on contact elements 18 so as to limit resiliently the upward movement of the contact elements 18. The pressure on elements 18 insures good electrical coupling between the contact elements 18 and the contact areas of the chip under test. The flexibility of film 12 and member 30 ensures that the pressure contact will not damage the wafer, and also compensates for minor variations in the points of contact between the probe head and selected chip, caused by variations in the vertical dimensions of the contact elements 18 and the contact areas 84 of the chip 81.

The transparency of the film 12 and the optical members 30 and 32, as well as the aperture 17 in the ground plane 16, facilitates use of a microscope 54 in conjunction with an X-Y (horizontal) positioning mechanism (not shown) to position the contact elements 18 immediately over the appropriate contact areas 84 of a selected chip of the wafer 80. A vertical positioning mechanism is then used to bring about relative vertical movement between the probe assembly and the wafer support 82 so as to establish pressure contact between the contact elements 18 and the appropriate contact area 84 of the selected chip. When the selected chip has been tested, the vertical and horizontal positioning mechanism automatically moves the wafer support to bring the next chip to be tested against the probe head, and that chip is then tested.

In the illustrated probe assembly, the characteristic impedance of the transmission lines of the probe head is matched to that of the transmission lines of the board to provide a high integrity signal constant characteristic impedance path between the contact areas of the chip and the test equipment.

The illustrated probe assembly provides several advantages over known probe assemblies. For example, it is possible to provide several hundred high integrity connections to a single integrated circuit chip without difficulty. The probe head itself is inexpensive and readily replaceable and can be manufactured using conventional fabrication techniques. In addition, the probe head is not easily damaged by contact with the chip under test and such contact does not damage the chip.

It will be appreciated that the present invention is not restricted to the preferred embodiment of the probe assembly that has been described and illustrated, and that variations may be made therein without departing from the scope of the invention as defined in the appended claims and equivalents thereof.

## Claims

1. A probe assembly for use in testing an integrated circuit embodied in an integrated circuit chip having a contact face that is incorporated in a wafer, comprising:
a support member having an aperture therein; and
a flexible membrane having a first main face for contacting said contact face of said chip and having a second opposite main face, the membrane spanning said aperture, both the support member and the membrane comprising dielectric material and portions of conductive material supported by the dielectric material in electrically-insulated relationship, the portions of conductive material of the membrane comprising a plurality of conductors at said first main face having first ends distributed over said first main face in a pattern that corresponds to the pattern in which contact areas are distributed over the contact face of the chip, and having second ends distributed about a peripheral region of the membrane, a plurality of inner contact elements, each mounted on a separate one of said first ends, and a plurality of outer connect elements, each mounted on a separate one of said second ends, and the portions of conductive material of the support member comprising a plurality of inner connect elements distributed about said aperture, and a plurality of transmission lines extending from the inner connect elements of the support member, the outer connect elements of the membrane being electrically coupled to respective inner connect elements of the support member.

2. A probe assembly according to claim 1 wherein said portions of conductive material of said membrane further comprise a ground plane at said second main face, said conductors and said ground plane forming a plurality of constant impedance transmission lines.

3. A probe assembly according to claim 1 wherein the second main face of the membrane is secured to the support member.

4. A probe assembly for use in testing an integrated circuit embodied in an integrated circuit chip having a contact face and including contact bumps extending from the contact face of the chip, the probe assembly comprising:
a support member having an aperture therein; and
a flexible membrane having a first main face for contacting said contact face of said chip and having a second opposite main face, the membrane spanning said aperture, both the support member and the membrane comprising dielectric material and portions of conductive material supported by the dielectric material in electrically-insulated relationship, the portions of conductive material of the membrane comprising a plurality of conductors at said first main face having first ends distributed over said first main face in a pattern that cor-. responds to the pattern in which contact bumps are distributed over the contact face of the chip, and having second ends distributed about a peripheral region of the membrane, a plurality of inner contact elements in the form of contact pads each mounted on a separate one of said first ends, and a plurality of outer contact elements each mounted on a separate one of said second ends, and the portions of conductive material of the support member comprising a plurality of inner connect elements distributed about said aperture, and a plurality of transmission lines extending from the inner connect elements of the support member, the outer connect elements of the membrane being electrically coupled to respective inner connect elements of the support member.

5. A probe assembly for use in testing an integrated circuit embodied in an integrated circuit chip having a contact face and including first contact bumps extending from the contact face of the chip and first contact pads on the surface of the chip, the probe assembly comprising:

a support member having an aperture therein; and

a flexible membrane having a first main face for contacting said contact face of said chip and having a second opposite main faces, the membrane spanning said aperture, both the support member and the membrane comprising dielectric material and portions of conductive material supported by the dielectric material in electrically-insulated relationship, the portions of conductive material of the membrane comprising a plurality of conductors at said first main face having first ends distributed over said first main face in a pattern that corresponds to the pattern in which said first contact bumps and first contact pads are distributed over the contact face of the chip, and having second ends distributed about a peripheral region of the membrane, said membrane further including a plurality of inner contact elements on the first main face thereof in the form of second contact pads and second contact bumps, each said inner contact element being mounted on a separate one of said first ends of said conductors such that each second contact bump engages a separate one of said first contact pads and each second contact pad engages a separate one of said first contact bumps, and a plurality of outer connect elements, each mounted on a separate one of said second ends of said conductors, the portions of conductive material of the support member comprising a plurality of inner connect elements distributed about said aperture, and a plurality of transmission lines extending from the inner connect elements of the support member, the outer connect elements of the membrane being electrically coupled to respective inner connect elements of the support member.

FIG.1

EP 0 304 868 A2

FIG.2

FIG.3

EP 0 304 868 A2

FIG. 4

FIG.5

FIG.6